# EUROPÄISCHE PATENTSCHRIFT

(11) **EP 2 126 161 B1**
(45) Veröffentlichungstag und Bekanntmachung des Hinweises auf die Patenterteilung: **12.01.2011**
(21) Anmeldenummer: 08709150.0
(22) Anmeldetag: 21.02.2008
(51) Int. Cl.: C30B 25/10, C30B 29/40, C30B 29/48, C23C 16/46

(54) **VORRICHTUNG UND VERFAHREN ZUM ABSCHEIDEN KRISTALLINER SCHICHTEN WAHLWEISE MITTELS MOCVD ODER HVPE**
DEVICE AND METHOD FOR SELECTIVELY DEPOSITING CRYSTALLINE LAYERS USING MOCVD OR HVPE
DISPOSITIF ET PROCÉDÉ DE DÉPÔT DE COUCHES CRISTALLINES PAR MOCVD OU HVPE

(30) Priorität: 24.02.2007 DE 102007009145
(43) Veröffentlichungstag der Anmeldung: 02.12.2009
(73) Patentinhaber: AIXTRON AG, 52134 Herzogenrath (DE)
(72) Erfinder: KÄPPELER, Johannes, 52146 Würselen (DE); SCHMITZ, Dietmar, 52072 Aachen (DE)
(74) Vertreter: Rieder, Hans-Joachim
(86) Internationale Anmeldenummer: PCT/EP2008/052110
(87) Internationale Veröffentlichungsnummer: WO 2008/101982

(56) Entgegenhaltungen:
- EP-B- 1 252 363
- DE-A1- 10 217 806
- DE-A1- 10 247 921
- JP-A- 11 180 796
- US-B1- 6 218 280
- US-B1- 6 569 765

## Beschreibung

Die Erfindung betrifft eine Vorrichtung zum Abscheiden ein oder mehrerer insbesondere kristalliner Schichten auf einem oder mehreren in einer Prozesskammer eines Reaktors auf einem Suszeptor angeordneten, insbesondere kristallinen Substraten, wobei dem von einer Suszeptorheizeinrichtung aktiv beheizbaren Suszeptor eine von einer Prozesskammerheizeinrichtung aktiv beheizbare Prozesskammerwand gegenüberliegt und ein Gaseinlassorgan, vorgesehen ist zum Einleiten von Prozessgasen in die Prozesskammer, wobei die Prozesskammerheizeinrichtung einen Kühlmittelkanal aufweist und beim aktiven Beheizen der Prozesskammerwand von der Außenseite der Prozesskammerwand beabstandet ist.

Die Erfindung betrifft drüber hinaus ein Verfahren zum Abscheiden ein oder mehrerer insbesondere kristalliner Schichten auf einem oder mehreren in einer Prozesskammer eines Reaktors auf einem Suszepfor angeordneten, insbesondere kristallinen Substraten, wobei der Suszeptor aktiv auf eine Suszeptortemperatur von mehr als 1000° C beheizt wird und zur Abscheidung der Schicht im HVPE-Verfahren die dem Suszeptor gegenüberliegende Prozesskammerwand aktiv auf eine Prozesskammerwandtemperatur beheizt wird, die im Bereich von +/- 200° um die Suszeptortemperatur liegt, wobei mittels eines Gaseinlassorganes Prozessgase in die Prozesskammer eingeleitet werden, welche zumindest ein Hydrid und ein Metallhalid aufweisen, wobei in derselben Prozesskammer zeitlich vor oder nach der Abscheidung der Schicht im HVPE-Verfahren eine weitere Schicht im MOCVD-Verfahren abgeschieden wird, wobei die Prozessgase mindestens ein Hydrid und eine metallorganische Verbindung aufweisen.

Eine Vorrichtung dieser Art ist aus der DE 102 47 921 A1 vorbekannt. Dort wird der Suszeptor von einem Boden einer Prozesskammer gebildet. In dem Boden der Prozesskammer ist eine Vielzahl von Substrathaltern angeordnet, die jeweils auf einem Gaspolster aufliegend durch den das Gaspolster bildenden Gasstrom drehangetrieben werden. Auf jedem Substrathalter liegt ein Substrat auf. Oberhalb des Suszeptors erstreckt sich vom Suszeptor beabstandet und dazu parallel verlaufend eine Prozesskammerwand, die die Decke der Prozesskammer ausbildet. Die Prozesskammer ist im Wesentlichen rotationssymmetrisch gestaltet. In das Zentrum der Prozesskammer ragt ein Gaseinlassorgan, mit dem Prozessgase in die Prozesskammer eingeleitet werden können. In der Prozesskammer soll ein HVPE-Kristallabscheidungsprozess durchgeführt werden. Hierzu werden Elemente der dritten Hauptgruppe in Form von Metallchloriden in die Prozesskammer eingeleitet. Zusätzlich werden Elemente der fünften Hauptgruppe in Form von Hydriden zusammen mit einem Trägergas in die Prozesskammer eingeleitet. Der Suszeptor wird von unten mittels einer wassergekühlten RF-Heizung beheizt. Er besteht hierzu aus einem elektrisch leitfähigen Material, nämlich aus beschichtetem Graphit. Die dem Suszeptor gegenüberliegende Prozesskammerwand ist ebenfalls aktiv beheizt. Auch hier wird die Energie über ein RF-Feld mittels einer RF-Heizspirale in die Prozesskammerdecke aus leitfähigem Material, beispielsweise Graphit eingeleitet.

Aus der DE 10217806 A1 ist ein MOCVD-Reaktor bekannt. Dort werden die Prozessgase über ein Gaseinlassorgan von oben durch eine aktiv gekühlte Prozesskammerdecke in die Prozesskammer eingeleitet. Der der Prozesskammerdecke gegenüberliegende Suszeptor wird von unten mittels einer RF-Heizspirale beheizt. Der Abstand zwischen Prozesskammerdecke und Suszeptor kann variiert werden.

Die DE 10133914 A1 beschreibt einen Reaktor zum Abscheiden ein oder mehrerer Schichten im MOCVD-Verfahren. Auch hier wird der Prozess in einer Prozesskammer mit kalter Prozesskammerdecke durchgeführt, der ein beheizter Suszeptor gegenüberliegt. Im Zentrum der Prozesskammer befindet sich ein Gaseinlassorgan, durch welches in getrennten Zuleitungskanälen eine metallorganische Verbindung und ein Hydrid jeweils zusammen mit einem Trägergas eingeleitet werden.

Aus der US 6,733,591 B2 ist eine Vorrichtung bekannt, mit der wahlweise Schichten im MOCVD-Verfahren oder HVPE-Verfahren in einer einzigen Prozesskammer durchgeführt werden können. Die Prozesskammer kann sowohl im Betrieb "hot-wall reactor" als auch im Betrieb "cold-wall reactor" betrieben werden. Bei dem Betrieb "cold-wall reactor" wird lediglich Trimethylgallium und ein Hydrid, beispielsweise Arsin oder NH₃ in die Prozesskammer eingeleitet. Wird der Reaktor im "hot-wall"-Betrieb betrieben, wird zusätzlich zum TMG HCl in die Prozesskammer eingeleitet, so dass sich die Galliumatome des zerfallenen TMG mit dem HCl zu Galliumchlorid verbinden können. Mit der dort beschriebenen Vorrichtung und mit dem in der US 6,218,280 B1 beschriebenen Prozess soll im HVPE-Verfahren, also im "hot-wall"-Prozess" eine dicke Zentralschicht auf einer zuvor im "cold-wall"-Verflhren abgeschiedenen dünnen MOCVD-Schicht abgeschieden werden. Diese Schicht wird dann von einer erneut im MOCVD-Verfahren abgeschiedenen dünnen Schicht überdeckt, so dass ein Galliumnitritsubstratmaterial entsteht.

Aus der US 6,569,765 ist ebenfalls ein hybrides Depositionssystem bekannt, bei dem wahlweise entweder ein Substrathalter oder die gesamte Wandung einer Prozesskammer beheizt werden können, um in der Prozesskammer entweder einen MOCVD-Prozess oder einen HVPE-Prozess durchführen zu können.

Aus der JP 11117071 A1 ist ein CVD-Reaktor bekannt, bei dem das Gaseinlassorgan und der Suszeptor getrennt voneinander temperierbar sind.

Aus der EP 12 52 363 B1 ist eine Prozesskammer einer CVD-Beschichtungseinrichtung vorbekannt, bei der das Gaseinlassorgan mit Hilfe von Kanälen durchströmender Kühlmittel temperiert werden kann.

Aus der US 4,558,660 ist eine CVD-Vorrichtung bekannt, bei der die Beheizung der Wände der Prozesskammer über Lampen erfolgt, die in einem wassergekühlten Gehäuse angeordnet sind.

Aus der WO 00/04205 ist ein MOCVD-Kaltwandreaktor bekannt. Die kalte Reaktorwand wird aktiv von einem kühlwasserdurchströmten Mantel gekühlt. Um die Prozesskammer und insbesondere die gekühlte Wandung zu reinigen, ist eine Prozesskammerwandungsheizung vorgesehen, mit der die Prozesskammerwandung auf eine Temperatur gebracht werden kann, dass in die Prozesskammer eingeleitetes gasförmiges HCL dort eine ätzende Wirkung entfaltet.

Aus der US 5,027,746 ist ein MOCVD-Reaktor bekannt, bei dem eine Prozesskammerwandung mittels Kühlflüssigkeit gekühlt wird.

Der Erfindung liegt die Aufgabe zugrunde, eine Vorrichtung, wie sie aus der eingangs genannten DE 10247921 A1 bekannt ist, derartig weiterzubilden, dass die Hydrid-Technologie auch dort möglich ist.

Gelöst wird die Aufgabe wie in Ansprüchen 1 und 8 angegeben.

Die Vorrichtung zeichnet sich im Wesentlichen dadurch aus, dass der Suszeptor, auf dem gegebenenfalls auf einem Substrathalter das Substrat liegt, in beiden Prozessarten von einer Suszeptorheizeinrichtung beheizt werden kann. Der Suszeptor kann den Boden einer Prozesskammer bilden. Bei der Suszeptorheizeinrichtung handelt es sich bevorzugt um eine RF-Heizspirale, die ein RF-Feld aufbaut, welches in dem aus Graphit bestehenden Suszeptor Wirbelströme erzeugt. Dadurch heizt sich der Suszeptor und mit ihm das Substrat auf. Gegenüberliegend dem Suszeptor liegt eine Prozesskammerwand. Diese verläuft bevorzugt parallel zum bevorzugt kreisscheibenförmigen Suszeptor. Diese Prozesskammerwand, die, sofern der Suszeptor unten angeordnet ist, eine Prozesskammerdecke bildet, kann wahlweise aktiv beheizt oder aktiv gekühlt werden. Es ist ein Beheizen der Prozesskammerwand möglich, so dass deren zur Prozesskammer hinweisende Oberfläche eine Temperatur annehmen kann, die ± 200° der Suszeptortemperatur beträgt. Mittels einer eigenständigen Kühleinrichtung kann die Prozesskammerwand aber alternativ zur Beheizung auch gekühlt werden. Die Kühlung sorgt dafür, dass trotz der von dem beheizten Suszeptor abgestrahlten Strahlungswärme die Temperatur der Prozesskammerwand weit unterhalb der Suszeptortemperatur bleibt. Die Temperatur der Prozesskammerwand kann auf Werte von weit unter einer Temperatur gehalten werden, die um mindestens 200° niedriger liegt als die Suszeptortemperatur. Es sind verschiedene bevorzugte Varianten vorgesehen, wie die aktive Kühlung bzw. die aktive Beheizung der Prozesskammerwand durchgeführt werden können. Bevorzugt wird die Prozesskammerwand in der gleichen Weise beheizt wie auch der Suszeptor, nämlich mittels einer RF-Heizspirale. Diese ist zur Prozesskammerwand beabstandet angeordnet. Das von der RF-Spirale erzeugte RF-Feld erzeugt in der bevorzugt aus Graphit bestehenden Prözesskammerwand Wirbelströme, die die Prozesskammerwand aufheizen. In dieser HVPE-Betriebsart kann durch geeignete Wahl der eingespeisten Energie die Prozesskammerwandtemperatur in einem Bereich variiert werden, der ± 200° in Bezug auf die Suszeptortemperatur beträgt. Die Suszeptortemperatur kann in einem Bereich zwischen 400 und 700° C variiert werden. Beim MOCVD-Prozess, bei dem bevorzugt Galliumnitrit abgeschieden wird, variiert die Suszeptortemperatur im Bereich bevorzugt zwischen 1400° C und 1600° C. Werden andere, insbesondere III-V-Kristalle auf einem Substrat abgeschieden, so kann die Temperatur auch darunter liegen, beispielsweise lediglich 1000° betragen. Soll innerhalb der Prozesskammer ein MOCVD-Prozess durchgeführt werden, so muss zur Vermeidung von parasitärem Wachstum an der Prozesskammerwand letztere auf Temperaturen weit unterhalb der Suszeptortemperatur gekühlt werden. Die Suszeptortemperaturen sind für verschiedene Wachstumsprozessschritte unterschiedlich. Die Suszeptortemperatur kann beispielsweise bei Niedrigtemperaturwachstumsschritten zwischen 400 und 500° C liegen. In diesem Temperaturbereich werden GaN-Nukleationsschichten beispielsweise auf Siliziumsubstraten mittels MOCVD abgeschieden. GaN-Hochtemperaturschichten werden dagegen bei Suszeptortemperaturen zwischen 950° C und 1200° C abgeschieden. Zur Abscheidung von InGaN im MOCVD-Prozess werden Suszeptortemperaturen zwischen 750° C und 850° C eingestellt. Beim Wachstum von AlGaN liegen die Suszeptortemperaturen im Bereich zwischen 950° C und 1700° C. Beim Abscheiden von AlN liegen die Suszeptortemperaturen im Bereich zwischen 1300° C und 1700° C. Die Prozesskammerwandheizeinrichtung, die von der RF-Heizspirale gebildet ist, kann gleichzeitig die Prozesskammerwandkühleinrichtung bilden. Die RF-Heizspirale wird von einem spiralförmigen Hohlkörper gebildet. Die Höhlung des Hohlkörpers ist von Kühlwasser durchströmt. Das Kühlwasser dient bei der Beheizung der Prozesskammerwand als Kühlmittel für die RF-Heizspirale, um zu vermeiden, dass diese sich auf unzulässige Temperaturen aufheizt. Diese Kühleinrichtung kann beim MOCVD-Prozess auch zur Kühlung der Prozesskammerwand verwendet werden. Hierzu wird der Abstand zwischen der RF-Heizspirale und der Außenseite der Prozesskammerwand verändert. Dies erfolgt mittels einer Verlagerungseinrichtung. Mit dieser Verlagerungseinrichtung wird die RF-Heizspirale an die Außenseite der Prozesskammerwandung angenähert bzw. die Prozesskammer in Richtung der RF-Heizspirale verlagert. Der Abstand zwischen RF-Heizspirale und Außenseite der Prozesskammerwand wird bevorzugt bis auf Null vermindert. In diesem Falle erfolgt der Wärmetransport von der Prozesskammerwand hin zur Kühleinrichtung nicht über Wärmestrahlung bzw. Wärmeleitung über ein Gas, sondern über direkte Kontaktwärmeableitung. In besonderen Fällen kann ausreichen, wenn der Abstand zwischen RF-Heizspirale und Außenseite der Prozesskammerwand sehr gering ist. Die Abstandsverminderung erfolgt entweder durch eine Verlagerung der Prozesskammerwand in Richtung auf die RF-Heizspirale oder durch eine Verlagerung der RF-Heizspirale in Richtung auf die Prozesskammerwand. Handelt es sich bei der Prozesskammerwand um die Prozesskammerdecke, so kann die Vertikalverlagerung der Prozesskammerdecke bis in Flächenkontakt zu der Unterseite der RF-Heizspirale durch Anheben der Prozesskammerdecke mittels einer Hubeinrichtung erfolgen. Letztere wird bevorzugt von einem Deckenträger gebildet. Um sicher zu stellen, dass ein ausreichend hoher Wärmetransport von der Prozesskammerwand in die Kühlkanäle erfolgt, liegen die ebenen Unterseiten der RF-Heizspirale in Flächen kontakt auf der Außenseite der Prozesskammerwand auf. Es können Federelemente vorgesehen sein, die die einzelnen Abschnitte der RF-Spirale gegen die Außenseite der Prozesskammerwand drücken. Bei diesen Federelementen kann es sich um Druckfedern handeln. Diese Druckfedern drücken beispielsweise unter Zwischenschaltung eines elektrischen Isolators auf die einzelnen Windungen der RF-Spirale. Es kann eine Vielzahl derartiger Federelemente vorgesehen sein. Diese können beispielsweise in gleichmäßiger Winkelverteilung angeordnet sein. Beispielsweise können die Federelemente in einem 90°-Winkelabstand angeordnet sein. Die Federelemente können sich an einer entsprechenden Halterung abstützen, die zusammen mit der RF-Spirale abgesenkt und wieder angehoben werden kann. In einer Alternative kann die Prozesskammerwand Kühlkanäle besitzen, durch die ein Kühlmedium fließt. Bevorzugt handelt es sich bei dem Kühlmedium um ein Material, welches sowohl im "cold-wall-Betrieb", als auch im "hot-wall-Betrieb" flüssig ist. Als Kühlmittel kommt beispielsweise flüssiges Gallium oder flüssiges Indium in Betracht. Der Suszeptor besitzt die Form einer Kreisscheibe und kann um seine Achse gedreht werden. In dem Suszeptor können Aussparungen vorgesehen sein. In diesen Aussparungen können Substrathalter einliegen. Die Substrathalter können auf einem Gaspolster liegen und von dem Gaspolster drehangetrieben werden. Auf jedem der mehreren Substrathalter kann ein Substrat liegen. Die Substrathalter werden mittels einer einzigen SuszeptorHeizeinrichtung beheizt. Der Suszeptor bildet somit eine beheizbare Wand der Prozesskammer aus, der eine wahlweise beheizbare oder kühlbare andere Wand gegenüberliegt. Die wahlweise aktiv gekühlte oder aktiv beheizte Prozesskammerwand bildet bevorzugt eine Prozesskammerdecke. Die Prozesskammerdecke ist horizontal ausgerichtet und besitzt ebenfalls eine Kreisscheibenform. Sie besitzt eine zentrale Öffnung, durch die ein Gaseinlassorgan, ragt. Mit diesem Gaseinlassorgan können die Prozessgase in die Prozesskammer eingeleitet werden. Die Prozesskammer wird von den Prozessgasen horizontal durchströmt. Die Stromrichtung ist vorzugsweise die Radialrichtung. Im MOCVD-Betrieb, bei dem die Prozesskammerdecke aktiv gekühlt wird, was entweder durch Durchleiten eines Kühlmittels durch Kühlkanäle der Prozesskammerdecke oder durch in Kontakt bringen mit der von der RF-Heizspirale gebildeten Kühlschlange erfolgen kann, werden durch voneinander getrennte Kanäle des Gaseinlassorganes geeignete Prozessgase in die Prozesskammer eingeleitet. Zum Abscheiden von Galliumnitrit wird beispielsweise Trimethylgallium und NH₃ in die Prozesskammer eingeleitet. Beim Abscheiden von Galliumnitrit beträgt die Suszeptortemperatur etwa 900° bis 1200° C. Die Temperatur der Prozesskaminerdecke beträgt dann maximal 700° C. Sie liegt vorzugsweise im Bereich zwischen 300° und 400° C. Soll in der Prozesskammer ein HVPE-Prozessschritt durchgeführt werden, so wird die Prozesskammerdecke nicht mehr aktiv gekühlt. Erfolgt die Kühlung über ein Kühlmittel, welches durch Kühlkanäle der Prozesskammerdecke geleitet wird, so wird der Kühlflüssigkeitsfluss angehalten. Erfolgt die Kühlung durch die wasserdurchflossene RF-Heizspirale, so wird diese von der Prozesskammerdecke beabstandet. Es reicht hier ein Abstand von wenigen Millimetern aus. Zur Durchführung des HVPE-Prozesses in der Prozesskammer wird nicht nur der Suszeptor, sondern auch die dem Suszeptor gegenüberliegende Prozesskammerdecke aktiv beheizt. Die Temperatur des Substrathalters kann Werte zwischen 1000° und 1400° C und bevorzugt Temperaturen bis 1600° C erreichen. Die Temperatur der Prozesskammerdecke wird auf einer Prozesskammerdeckentemperatur im Bereich von ± 200° um die jeweilige Suszeptortemperatur geheizt. Zur Abscheidung wird ein Hydrid und ein Metallhalid verwendet. Hierbei handelt es sich bevorzugt um ein Metallchlorid. Anstelle von Chlor kann aber auch Jod oder Brom oder Fluor verwendet werden. Zur Erzeugung des Metallchlorides wird HCl verwendet. Die Metallchloridbildung, beispielsweise die Bildung von Galliumchlorid kann innerhalb der Prozesskammer erfolgen. Als Galliumquelle kann entweder flüssiges Gallium gewählt werden, über welches HCl geleitet wird, so dass sich dort Galliumchlorid bildet. Es kann aber auch Trimethylgallium oder eine andere flüchtige Galliumverbindung in die Prozesskammer eingeleitet werden. Diese Verbindung kann dort pyrolytisch zerfallen. Das dabei frei werdende Gallium reagiert mit HCl zu Galliumchlorid. Beim HVPE-Betrieb, also bei geheizter Prozesskammerwand, verläuft der Temperaturgradient zwischen Suszeptor und diesem gegenüberliegender Prozesskammerwand flach. Der Temperaturgradient kann ansteigend oder absteigend verlaufen, er kann aber auch Null betragen. Beim MOCVD-Prozess ist ein sehr großer Temperaturgradient vorhanden. Der MOCVD-Prozess kann aber auch bei geheizter Prozesskammerdecke durchgeführt werden. Es ist sogar möglich und in einer bevorzugten Variante des Verfahrens auch vorgesehen, dass beim MOCVD-Prozess geringe Mengen eines Halides dem Prozessgas beigemischt wird. Auch hier kann es sich neben dem bevorzugten Chlor um Fluor, Jod oder auch Brom handeln. Bevorzugt wird aber HCl den Prozessgasen beigemischt. Dies erfolgt aber in einer Menge, bei der eine nicht 100 %-ige Umsetzung von TMGa oder TEGa zu GaCl führt. Es sind somit auch Mischformen zwischen reiner MOCVD und reiner HVPE möglich.

Ausführungsbeispiele der Erfindung werden nachfolgend anhand beigefügter Zeichnungen erläutert. Es zeigen:
- Fig. 1: in schematischer Halbschnittdarstellung die wesentlichen Elemente der Prozesskammer eines Reaktoreingerichtes 1 in einer HVPE- Betriebsstellung,
- Fig. 2: eine Darstellung gemäß Fig. 1, wobei die Prozesskammerdecke 4 in Richtung auf die RF-Heizspirale angehoben worden ist;
- Fig. 3: eine Variante, bei der die RF-Heizspirale 12 in Richtung auf die Pro- zesskammerdecke 4 abgesenkt ist;

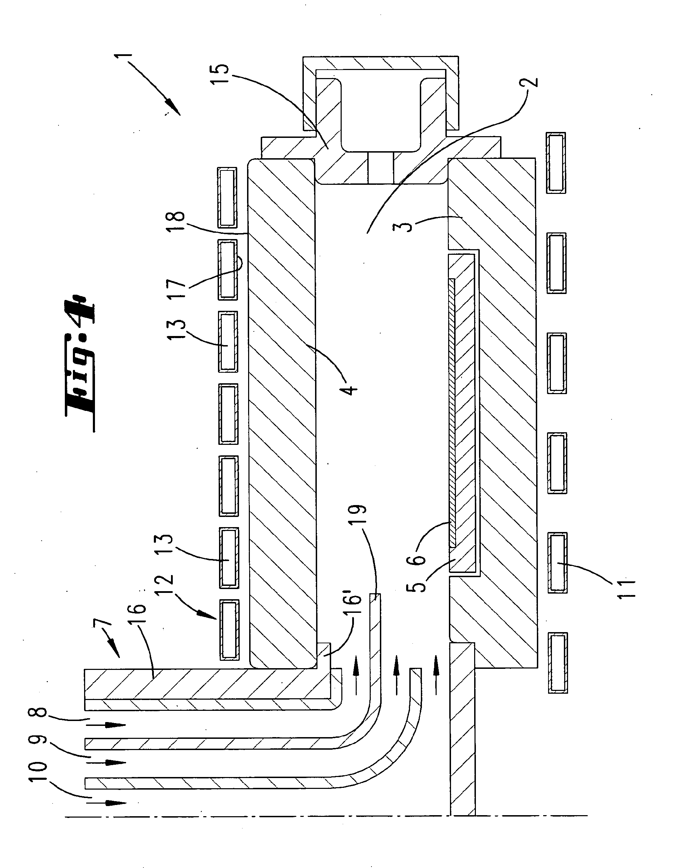

- Fig. 4: eine Darstellung gemäß Fig. 1 mit einer verlängerten Trennwandung 19 zwischen zwei Prozessgaszuleitungskanälen ;
- Fig. 5: eine Alternative zu dem in Fig. 1 dargestellten Ausführungsbeispiel, bei dem innerhalb der Prozesskammerdecke 4 Kühlmittelkanäle 14 vorge- sehen sind;
- Fig. 6: eine Darstellung gemäß Fig. 1 einer weiteren Alternative und
- Fig. 7: eine Darstellung gemäß Fig. 1 einer weiteren Alternative.

Die erfindungsgemäße Vorrichtung befindet sich in einem nicht dargestellten Reaktorgehäuse. Das mit der Bezugsziffer 1 bezeichnete Reaktoreingerichte besteht im Wesentlichen aus einem Suszeptor 3, welcher aus Graphit gefertigt ist und der eine Kreisscheibenform besitzt. Innerhalb des Suszeptors 3 befinden sich eine Vielzahl von napfförmigen Ausnehmungen, die in gleichmäßiger Winkelverteilung um das Zentrum des Suszeptors 3 angeordnet sind. In diesen Aussparungen liegen Substrathalter 5 ein. Die Substrathalter 5 besitzen eine Kreisscheibenform und lagern auf Gaspolstern. Diese Gaspolster sind auch in der Lage, die Substrathalter 5 drehanzutreiben. Auf jedem der Substrathalter 5 liegt ein Substrat 6. Bei dem Substrat 6 kann es sich um eine einkristalline Kristallscheibe handeln, auf der ein oder mehrere kristalline Schichten abgeschieden werden sollen.

Der in einer Horizontalebene liegende Suszeptor 3 wird von unten her mit einer Suszeptorheizeinrichtung 11 beheizt. Bei der Suszeptorheizeinrichtung 11 handelt es sich um eine RF-Heizspirale, die als Kühlschlange ausgebildet ist. Durch die RF-Heizspirale fließt Wasser als Kühlmittel. Oberhalb des Suszeptors 3 befindet sich die Prozesskammer 2, die in Horizontalrichtung von den Prozessgasen durchströmt wird. Die Prozessgase werden mittels eines Gaseinlassorganes 7 in das Zentrum der Prozesskammer 2 eingeleitet. Das Gaseinlassorgan 7 besitzt im Ausführungsbeispiel insgesamt drei voneinander getrennte Prozessgaszuleitungen 8, 9, 10, durch die die Prozessgase in unterschiedlichen Höhen in die Prozesskammer 2 eingeleitet werden.

Das Gaseinlassorgan 7 wird von einem Deckenträger 16, der die Form eines Rohres hat, umgeben. Der Deckenträger 16 bildet eine radial auswärts ragende Stufe 16' aus, auf der eine aus Graphit bestehende Decke 4 aufliegt.

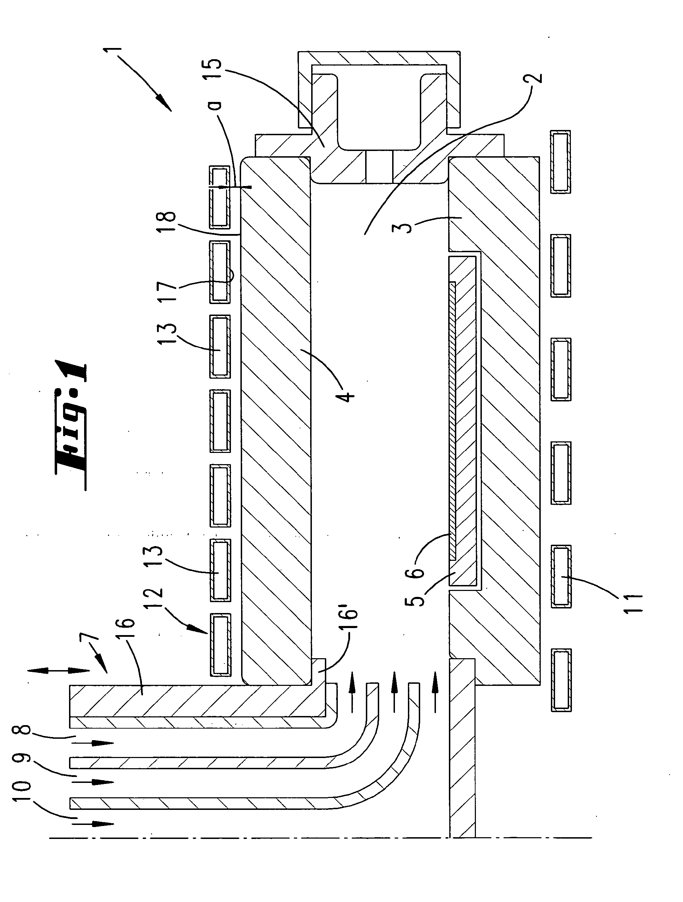

Die Prozesskammerdecke 4 kann ebenso wie der Suszeptor 3 beheizt werden. Hierzu ist eine Prozesskammerwandheizeinrichtung 12 ebenfalls in Form einer RF-Heizspirale vorgesehen, die aus einer Kühlschlange besteht. Durch die Hohlräume der RF-Heizspirale 12 fließt Wasser als Kühlmittel. In der in Figur 1 dargestellten Betriebsart, in der ein HVPE-Prozess durchgeführt werden kann, besitzt die Heizspirale 12 einen vertikalen Abstand a von etwa 1 mm zur Oberseite 18 der Prozesskammerdecke 4.

Die Umfangsaußenwand der Prozesskammer 2 wird von einem Gasauslassring 15 ausgebildet, durch welchen das Prozessgas wieder aus der Prozesskammer 2 heraustreten kann.

Um in der Prozesskammer 2 einen MOCVD-Prozess durchführen zu können, kann die Prozesskammerdecke 4 gekühlt werden. Die Kühlung erfolgt durch die RF-Heizspirale 12. Diese bildet somit eine Heiz-Kühl-Spirale aus. Entweder diese oder die Prozesskammerdecke 4 ist beweglich, so dass die Heiz-Kühl-Spirale in flächige Anlage an die Prozesskammerdecke 4 gebracht werden kann.

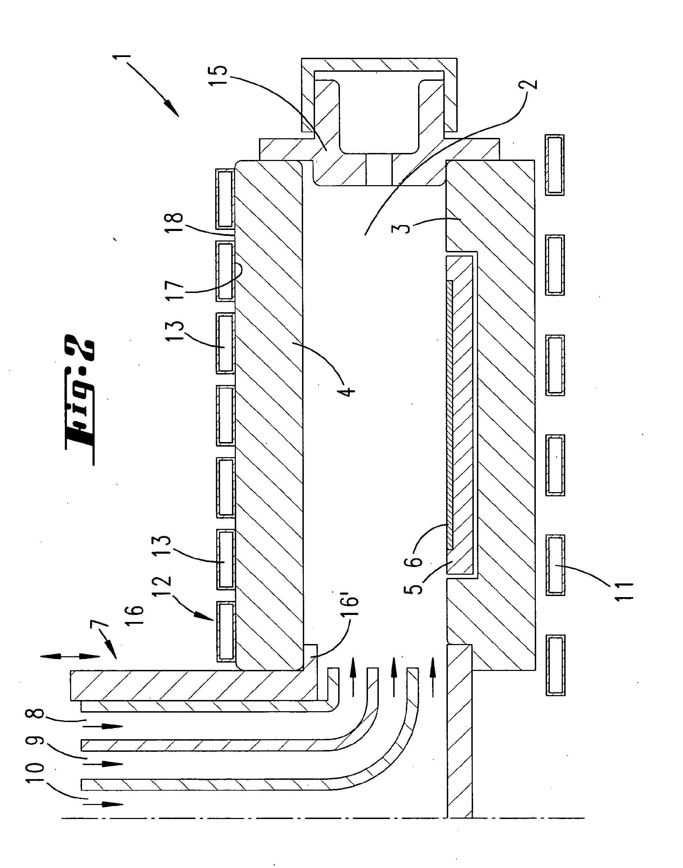

Bei der in Figur 2 dargestellten Variante ist der Deckenträger 16 in Vertikalrichtung verlagerbar. Hierzu dient eine nicht dargestellte Hubeinrichtung. Durch Anheben der Prozesskammerdecke aus der in Figur 1 dargestellten Abstandsstellung in die in Figur 2 dargestellte Anlagestellung tritt die Oberseite 18 der Prozesskammerdecke 4 in flächige Anlage zu der ebenen Unterseite 17 der einzelnen Windungen der RF-Heiz-Kühl-Spirale 12. Die Heiz-Kühl-Spirale 12 wird bei dieser Prozessart nicht bestromt. Durch die einen rechteckigen Querschnitt aufweisenden Kanäle 13 fließt aber Wasser als Kühlmittel. Zufolge des großflächigen Flächenkontaktes zwischen der Unterseite 17 und der Oberseite 18 erfolgt ein Wärmeaustausch. Wärme kann von der Prozesskammerwand 4 abgeführt werden. Hierdurch wird die Strahlungswärme, die vom Suszeptor 3 auf die Prozesskammerdecke 4 übertragen wird, abgeführt mit der Folge, dass die Temperatur der Prozesskammerdecke sinkt. Durch Variation des Kühlmittelflusses durch den Kühlmittelkanal 13 kann die Prozesskammerdeckentemperatur eingestellt werden.

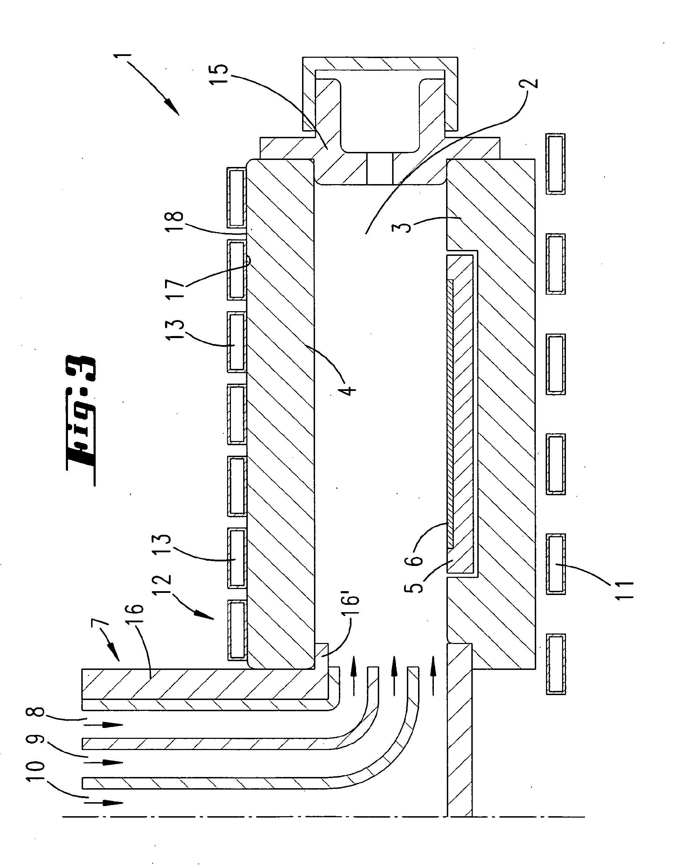

Bei der in Figur 3 dargestellten Variante ist die Heiz-Kühl-Spirale 12 auf die Oberseite 18 der Prozesskammerdecke 4 abgesenkt worden. Sowohl in der Betriebsstellung gemäß Figur 2 als auch in der Variante gemäß Figur 3 können nicht dargestellte Federelemente vorgesehen sein, die an verschiedenen Stellen in Vertikalrichtung nach unten auf die Heiz-Kühl-Spirale wirken, um die ebene Unterseite 17 gegen die ebene Oberseite 18 der Prozesskammerdecke 4 zu drücken.

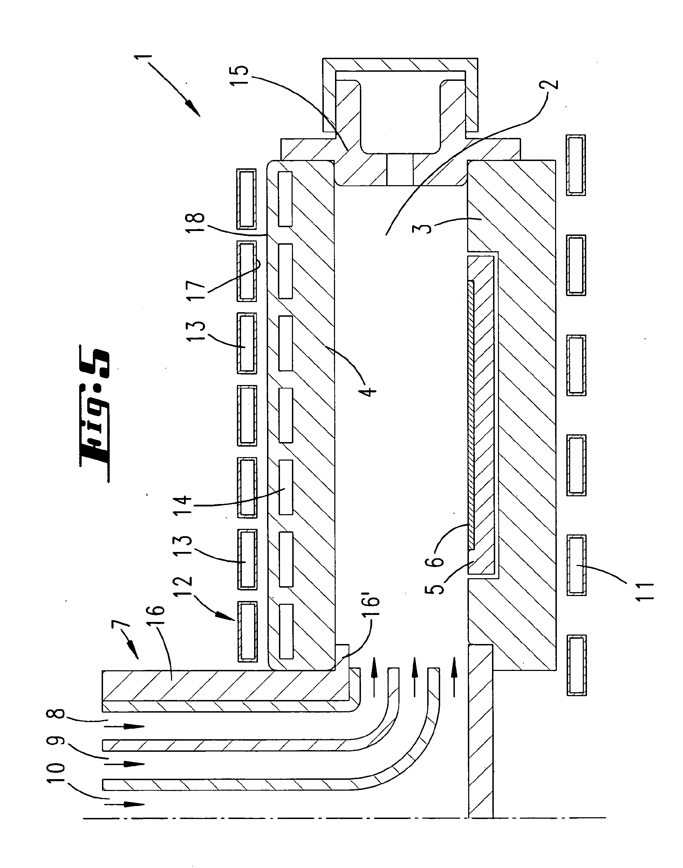

Bei dem in der Figur 5 dargestellten weiteren Ausführungsbeispiel braucht zum Wechsel der Betriebsart die Prozesskammerwandheizeinrichtung 12 nicht verlagert werden. Bei diesem Ausführungsbeispiel besitzt die Prozesskammerdecke 4 Kühlmittelkanäle 14, durch die ein Kühlmittel fließt. Um zu vermeiden, dass das in dem Kühlmittelkanal 14 fließende bzw. stehende Kühlmittel beim Aufheizen der Prozesskammerdecke 4 nicht verdampft, ist vorgesehen, dass das Kühlmittel eine Verdampfungstemperatur besitzt, die oberhalb der maximal zulässigen Prozesskammerdeckentemperatur liegt. Als Kühlmittel kommt beispielsweise ein flüssiges Metall wie Gallium oder Indium in Betracht.

Mit der zuvor beschriebenen Vorrichtung kann innerhalb eines Prozesses eine Vielzahl von Schichten auf ein Substrat 6 abgeschieden werden. Die Schichten können in zwei verschiedenen Verfahrensvarianten abgeschieden werden.

Erfolgt die Schichtabscheidung im MOCVD-Betrieb, so wird die Prozesskammerdecke 4 in der zuvor beschriebenen Weise gekühlt. Die Substrattemperatur kann hier einen Wert zwischen 350° und 700° C oder eine größere Temperatur annehmen. Die Deckentemperatur ist deutlich niedriger als die Substrattemperatur. Sie kann zwischen 200° und 500° C betragen. Zum Abscheiden von beispielsweise Galliumnitrit wird durch die zuunterst liegende Prozessgaszuleitung 10 Stickstoff oder Wasserstoff und NH₃ geleitet. Durch die mittlere Prozessgaszuleitung 9 wird Stickstoff oder Wasserstoff und ein metallorganisches Material, beispielsweise Trimethylgallium geleitet. Anstelle von Trimethylgallium kann aber auch Trimethylindium oder Trimethylaluminium durch die mittlere Prozessgaszuleitung geleitet werden. Durch die zuoberst liegende Prozessgaszuleitung wird ebenfalls ein Trägergas in Form von Stickstoff oder Wasserstoff geleitet. Zusätzlich kann hier NH₃ in die Prozesskammer eingeleitet werden. Soll eine andere Kristallzusammensetzung abgeschieden werden, so kann auch ein anderes Hydrid, beispielsweise Arsin oder Phosphin in die Prozesskammer eingeleitet werden. Es kann auch eine Mischung der zuvor beschriebenen Gase in die Prozesskammer 2 eingeleitet werden, um Mischkristalle abzuscheiden.

Auf eine derart im MOCVD-Verfahren abgeschiedene Schicht oder Schichtenfolge kann eine Schicht oder kann eine Schichtenfolge im HVPE-Prozess abgeschieden werden. Hierzu wird die Prozesskammerdecke 4 in der oben beschriebenen Weise mittels der Heiz-Kühl-Einrichtung 12 beheizt. Die Prozesstemperaturen können hier durchaus höher sein als die zuvor erwähnten Prozesstemperaturen. Die Substrattemperatur kann zwischen 1000° und 1200° C liegen oder in einem größeren, oben genannten Temperaturbereich liegen. Die Temperatur der Prozesskammerdecke 4 kann dieselbe Temperatur wie der Suszeptor 3 besitzen. Durch geeignete Wahl der Energiezuführung kann diese Temperatur aber auch größer sein als die Substrattemperatur oder kleiner sein als die Substrattemperatur. Beim HVPE-Prozess wird durch die zuunterst liegende Prozessgaszuleitung 10 ebenfalls Stickstoff oder Wasserstoff und ein Hydrid, beispielsweise NH₃ in die Prozesskammer 2 eingeleitet. Durch die mittlere Prozessgaszuleitung 9 kann ein Trägergas wie Wasserstoff oder Stickstoff zusammen mit einer metallorganischen Verbindung, beispielsweise Trimethylgallium eingeleitet werden. Letzteres zerfällt beim Eintritt in die Prozesskammer 2. Durch die zuoberst liegende Prozessgaszuleitung 8 kann neben einem Trägergas HCl in die Prozesskammer 2 eingeleitet werden.

Beim HVPE-Prozess kann der Abstand a auch 3 bis 5 mm betragen. Dieser Abstand ist vorteilhaft, da durch den vergrößerten Abstand a ein verminderter Wärmeabfluss über die Wasserkühlung erfolgt.

MOCVD-Prozessschritte und HVPE-Prozessschritte können in beliebiger zeitlicher Reihenfolge aneinander gehängt werden.

Mit dem zuvor beschriebenen Reaktor lässt sich auch die Prozesskammer 2 reinigen. Hierzu dient ein Ätzschritt, bei welchem sowohl der Suszeptor 3 als auch die Prozesskammerdecke 4 aktiv beheizt werden. In die Prozesskammer wird dann neben einem Trägergas lediglich HCl eingeleitet. Die HCl-Einleitung kann durch eine der drei dargestellten Prozessgaszuleitungen 8, 9, 10 erfolgen.

Die Heizung der dem Suszeptor 3 gegenüberliegenden Prozesskammerwand 4, also beispielsweise die Prozesskammerdecke, erfolgt mit einer Heiz-Kühl-Spirale. Diese bildet die Antenne einer RF-Heizeinrichtung.

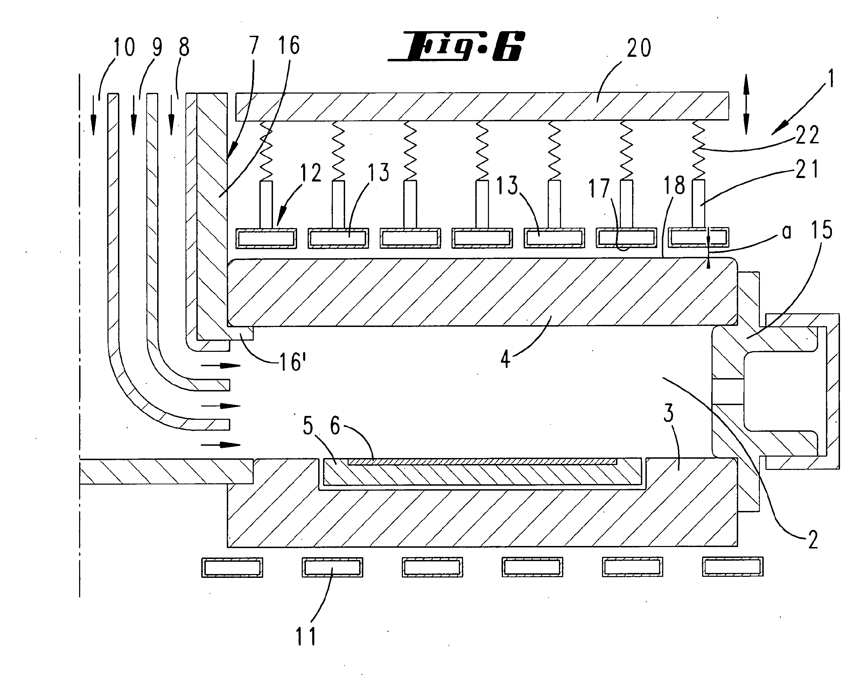

Bei dem in der Figur 6 dargestellten Ausführungsbeispiel sind die Federelemente, mit denen die als Kühlschlange wirkende Spirale 12 zusammenwirkt, mit der Bezugsziffer 22 bezeichnet. Es handelt sich um eine Vielzahl von Druckfedern 22, die sich nach oben hin an einer Halterung 20 abstützen. Nach unten hin stützen sich die Federelemente 22 auf elektrischen Isolatorkörpern 21 ab. Letztere liegen auf den einzelnen Windungen des spiralförmigen Kanals 12. Die in der Figur 6 dargestellte Anordnung kann in gleichmäßiger Winkelverteilung vorgesehen sein. Es ist insbesondere vorgesehen, dass alle 90° ein derartiges Federelement 22 unter Zwischenschaltung eines Isolierkörpers 21 auf den spiralförmigen Kanal 12 wirken. Wird die in der Figur 1 als IR-Spule wirkende Spirale 12 abgesenkt, so verlagert sich die Halterung 20 zunächst zusammen mit der Spirale 12, bis diese mit ihrer Unterseite 17 die Oberseite 18 der Prozesskammerdecke 4 berührt. Zur Vorspannung der Druckfedern 22 bewegt sich hernach die Halterung 20 noch etwas herab. Hierdurch werden die einzelnen Windungsabschnitte der Spule mittels Federkraft gegen die Oberseite 18 der Prozesskammerwandung 4 angedrückt. Dies kompensiert thermische Ausdehnungen der Prozesskammerdecke.

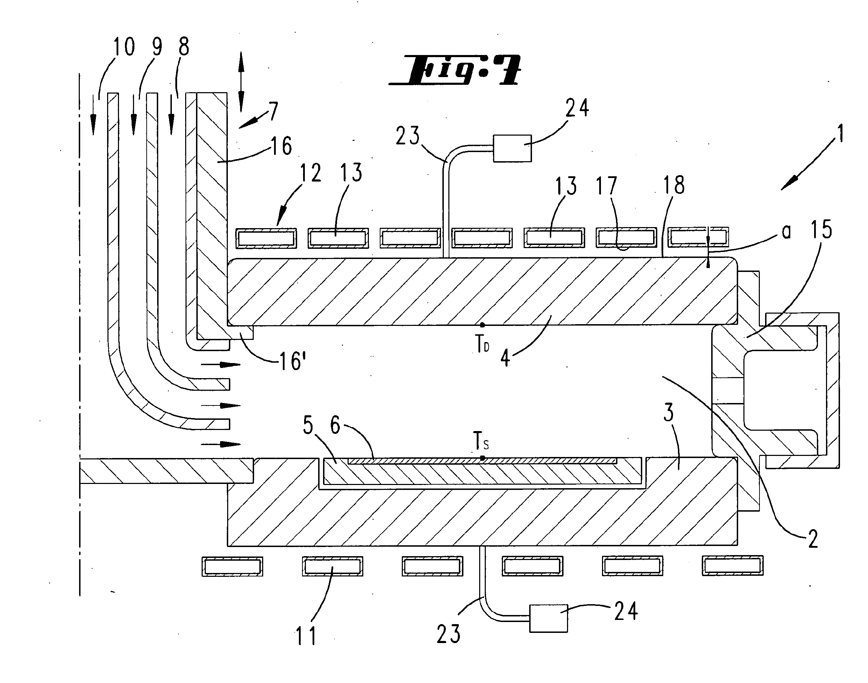

Bei der in Figur 7 dargestellten Variante sind Mittel dargestellt, mit denen die Suszeptortemperatur Ts bzw. die Deckentemperatur T_{D} gemessen werden können. Diese beiden Temperaturen werden nicht direkt gemessen, sondern indirekt über jeweils ein Pyrometer 24. Das Pyrometer 24 ist mit einem Lichtleiter 23 jeweils mit der Oberfläche von Prozesskammerdecke 4 bzw. der Unterfläche des Suszeptors 3 verbunden. Die Temperaturen T_{D} und Ts können über Tabellen oder zuvor ermittelte funktionelle Zusammenhänge bestimmt werden. Die Temperaturmesseinrichtung gemäß Figur 7 kann selbstverständlich auch an einer Vorrichtung gemäß Figur 6 vorgesehen sein.

## Patentansprüche

1. Vorrichtung zum Abscheiden ein oder mehrerer insbesondere kristalliner Schichten auf einem oder mehreren in einer Prozesskammer (2) eines Reaktors (1) auf einem Suszeptor (3) angeordneten, insbesondere kristallinen Substraten (6), wobei dem von einer Suszeptorheizeinrichtung (11) aktiv beheizbaren Suszeptor (3) eine von einer Prozessklmmerheizeinrichtung (11, 12) aktiv beheizbare Prozesskammerwand (4) gegenüberliegt und ein Gaseinlassorgan (7) vorgesehen ist zum Einleiten von Prozessgasen in die Prozesskammer, wobei die Prozesskammerheizeinrichtung (11, 12) einen Kühlmittelkanal (13) aufweist und beim aktiven Beheizen der Prozesskammerwand (4) von der Außenseite (18) der Prozesskammerwand (4) beabstandet ist, **dadurch gekennzeichnet, dass** die Prozesskammerwand (4) wahlweise sowohl aktiv beheizbar als auch aktiv kühlbar ist, wozu der Kühlmittelkanal (13) eine Prozesskammerwandkühleinrichtung (12) ausbildet, wobei der Abstand zwischen Prozesskammerwandkühleinrichtung (12) und Prozesskammerwand (4) mittels einer Verlagerungseinrichtung insbesondere in Form einer Hubeinrichtung von der beabstandeten Heizstellung in eine Kühlstellung veränderbar ist.

2. Vorrichtung nach Anspruch 1, **dadurch gekennzeichnet, dass** der Abstand zwischen der Prozesskammerwandkühleinrichtung (12) und Prozesskammerwand (4) in der Kühlstellung Null oder nahe Null ist, so dass die Kühlmittelkanalaußenseite (17) in Flächenkontakt zur Außenseite (18) der Prozesskammerwand (4) steht.

3. Vorrichtung nach einem oder mehreren der vorangehenden Ansprüche
, **dadurch gekennzeichnet, dass** die Prozesskammerwandheizeinrichtung (12) eine Heiz-Kühl-Spirale ist.

4. Vorrichtung nach einem oder mehreren der vorangehenden Ansprüche
, **dadurch gekennzeichnet, dass** die Verlagerungseinrichtung entweder die Prozesskammerwand (4) relativ zur Heiz-Kühl-Spirale (12) oder die Heiz-Kühl-Spirale (12) relativ zur Prozesskammerwand (4) verlagert.

5. Vorrichtung nach einem oder mehreren der vorangehenden Ansprüche
, **dadurch gekennzeichnet, dass** die gegen die Heiz-Kühl-Spirale (12) verlagerbare Prozesskammerwand (4) die Prozesskammerdecke ist und die Hubeinrichtung ein die Decke tragender Deckenträger (16).

6. Vorrichtung nach einem oder mehreren der vorangehenden Ansprüche
, **gekennzeichnet durch** auf die Heiz-Kühl-Spirale (12) wirkende Federelemente (22), zur elastischen Beaufschlagung der Windungen der Heiz-Kühl-Spirale (12) in Richtung auf die Prozesskammerwand (4) zur Aufrechterhaltung einer Flächenanlage der Unterseite (17) der Heiz-Kühl-Spirale (12) auf der Oberseite (18) der Prozesskammerwand (4).

7. Vorrichtung nach einem oder mehreren der vorangehenden Ansprüche
, **dadurch gekennzeichnet, dass** das Substrat (6) auf einem drehbar dem Suszeptor (3) zugeordneten Substrathalter (5) angeordnet ist.

8. Verfahren zum Abscheiden ein oder mehrerer insbesondere kristalliner Schichten auf einem oder mehreren in einer Prozesskammer (2) eines Reaktors (1) auf einem Suszeptor (3) angeordneten, insbesondere kristallinen Substraten (6), wobei der Suszeptor (3) aktiv auf eine Suszeptortemperatur von mehr als 1000° C beheizt wird und zur Abscheidung der Schicht im HVPE-Verfahren die dem Suszeptor (3) gegenüberliegende Prozesskammerwand (4) aktiv auf eine Prozesskammerwandtemperatur beheizt wird, die im Bereich von +/- 200° um die Suszeptortemperatur liegt, wobei mittels eines Gaseinlassorganes (7) Prozessgase in die Prozesskammer (2) eingeleitet werden, welche zumindest ein Hydrid und ein Metallhalid aufweisen, wobei in derselben Prozesskammer zeitlich vor oder nach der Abscheidung der Schicht im HVPE-Verfahren eine weitere Schicht im MOCVD-Verfahren abgeschieden wird, wobei die Prozessgase mindestens ein Hydrid und eine metallorganische Verbindung aufweisen, **dadurch gekennzeichnet, dass** bei der Durchführung des MOCVD-Verfahrens die Prozesskammerwand (4) auf eine Prozesskammerwandtemperatur gekühlt wird, die mehr als 200° unterhalb der Suszeptortemperatur liegt, wozu entweder eine einen Kühlmittelkanal (13) aufweisende und beim aktiven Beheizen der Prozesskammerwand (4) von der Außenseite (18) der Prozesskammerwand (4) beabstandete Prozesskammerheizeinrichtung (11, 12) mittels einer Hubeinrichtung von der beabstandeten Heizstellung in eine Kühlstellung abgesenkt wird oder durch in der Prozesskammerwand (4) angeordnete Kühlmittelkanäle (14), ein flüssiges Metall fließt, welches einen Siedepunkt besitzt, der oberhalb der höchsten Prozesskammerwandtemperatur liegt.

9. Verfahren nach Anspruch 8, **dadurch gekennzeichnet, dass** die Prozessgase zumindest ein Element der zweiten oder dritten Hauptgruppe und ein Element der fünften oder sechsten Hauptgruppe umfassen.

10. Verfahren nach einem oder mehreren der Ansprüche 8 oder 9
, **dadurch gekennzeichnet, dass** beim MOCVD-Prozess das Element der zweiten oder dritten Hauptgruppe die metallorganische Verbindung und das Element der fünften oder sechsten Hauptgruppe das Hydrid ist und dass beim HVPE-Verfahren dieselben Ausgangsstoffe verwendet werden und zusätzlich HCl als Transportmittel für das beim Eintritt in eine heiße Zone der Prozesskammer (2) zerfallene Element der metallorganischen Verbindung.

11. Verfahren nach einem oder mehreren der Ansprüche 8 bis 10
, **dadurch gekennzeichnet, dass** die Prozesskammerwand (4) mittels einer Heiz-Kühl-Spirale (12) geheizt wird und durch in Kontakt bringen mit der Heiz-Kühl-Spirale (12) durch das durch einen Kühlkanal (13) der Heiz-Kühl-Spirale (12) fließende Kühlmittel gekühlt wird.

12. Verfahren nach einem oder mehreren der Ansprüche 8 bis 11
, **gekennzeichnet durch** eine Vielzahl von umfangsversetzt angeordneten Federelementen (22), die sich nach oben hin an einer Halterung (20) abstützen und nach unten hin die Heiz-Kühl-Spirale (12) beaufschlagen.

13. Verfahren nach einem oder mehreren der Ansprüche 8 bis 12
, **dadurch gekennzeichnet, dass** bei beheizter oder gekühlter Prozesskammerdecke (4) zusammen mit einer metallorganischen Komponente eines Elementes der III-Hauptgruppe ein Halid, insbesondere in Form von HCl in die Prozesskammer eingebracht wird, wobei die Konzentration des Halids derart gering ist, dass keine vollständige Umsetzung der metallorganischen Komponente zu einem Metallchlorid erfolgt.

## Claims

1. Apparatus for depositing one or more layers, in particular crystalline layers, on one or more substrates (6), in particular crystalline substrates, disposed on a susceptor (3) in a process chamber (2) of a reactor (1), wherein a process chamber wall (4) that can be actively heated by a process chamber heating device (11, 12) lies opposite the susceptor (3) that can be actively heated by a susceptor heating device (11), and a gas inlet element (7) is provided for introducing process gases into the process chamber, the process chamber heating device (11, 12) having a coolant channel (13) and being situated at a distance from the exterior (18) of the process chamber wall (4) during the active heating of said process chamber wall (4), **characterized in that** the process chamber wall (4) can be both actively heated and actively cooled, according to choice, for which purpose the coolant channel (13) forms a process chamber wall cooling device (12), the distance between the process chamber wall cooling device (12) and the process chamber wall (4) being variable from the spaced apart heating position into a cooling position by means of a displacement device, in particular in the form of a lifting device.

2. Apparatus according to Claim 1, **characterized in that** the distance between the process chamber wall cooling device (12) and the process chamber wall (4) in the cooling position is zero or almost zero, so that the exterior (17) of the coolant channel is in surface-area contact with the exterior (18) of the process chamber wall (4).

3. Apparatus according to one or more of the preceding claims, **characterized in that** the process chamber wall heating device (12) is a heating-cooling coil.

4. Apparatus according to one or more of the preceding claims, **characterized in that** the displacement device displaces either the process chamber wall (4) in relation to the heating-cooling coil (12) or the heating-cooling coil (12) in relation to the process chamber wall (4).

5. Apparatus according to one or more of the preceding claims, **characterized in that** the process chamber wall (4) that can be displaced toward the heating-cooling coil (12) is the process chamber ceiling, and the lifting device is a ceiling carrier (16) carrying the ceiling.

6. Apparatus according to one or more of the preceding claims, **characterized by** spring elements (22) acting on the heating-cooling coil (12), for resiliently urging the turns of the heating-cooling coil (12) in the direction of the process chamber wall (4) to maintain surface contact of the underside (17) of the heating-cooling coil (12) with the upper side (18) of the process chamber wall (4).

7. Apparatus according to one or more of the preceding claims, **characterized in that** the substrate (6) is disposed on a substrate holder (5) rotatably associated with the susceptor (3).

8. Method for depositing one or more layers, in particular crystalline layers, on one or more substrates (6), in particular crystalline substrates, disposed on a susceptor (3) in a process chamber (2) of a reactor (1), the susceptor (3) being actively heated to a susceptor temperature of more than 1000°C and, for depositing the layer by the HVPE process, the process chamber wall (4) that lies opposite the susceptor (3) being actively heated to a process chamber wall temperature which lies in the range of +/-200°C above or below the susceptor temperature, process gases which comprise at least a hydride and a metal halide being introduced into the process chamber (2) by means of a gas inlet element (7), and a further layer being deposited in the same process chamber by the MOCVD process at a time before or after the deposition of the layer by the HVPE process, the process gases comprising at least a hydride and an organometallic compound, **characterized in that**, when carrying out the MOCVD process, the process chamber wall (4) is cooled to a process chamber wall temperature which lies more than 200° below the susceptor temperature, for which purpose either a process chamber heating device (11, 12) having a coolant channel (13) and situated at a distance from the exterior (18) of the process chamber wall (4) during the active heating of said process chamber wall (4) is lowered from the spaced apart heating position into a cooling position by means of a lifting device, or a liquid metal having a vaporization point that lies above the highest process chamber wall temperature flows through coolant channels (14) disposed in the process chamber wall (4).

9. Method according to Claim 8, **characterized in that** the process gases comprise at least an element of the second or third main group and an element of the fifth or sixth main group.

10. Method according to either or both of Claims 8 and 9, **characterized in that**, in the case of the MOCVD process, the element of the second or third main group is the organometallic compound and the element of the fifth or sixth main group is the hydride and **in that**, in the case of the HVPE process, the same starting materials are used and, in addition, HCl as a transporting medium for the element of the organometallic compound that decomposes when it enters a hot zone of the process chamber (2).

11. Method according to one or more of Claims 8 to 10, **characterized in that** the process chamber wall (4) is heated by means of a heating-cooling coil (12) and is cooled by bringing it into contact with the heating-cooling coil (12), by the coolant flowing through a cooling channel (13) of the heating-cooling coil (12).

12. Method according to one or more of Claims 8 to 11, **characterized by** a multiplicity of spring elements (22) disposed offset around the circumference, which are supported in the upward direction on a mount (20) and act in the downward direction on the heating-cooling coil (12).

13. Method according to one or more of Claims 8 to 12, **characterized in that**, with a heated or cooled process chamber ceiling (4), a halide, in particular in the form of HCl, is introduced into the process chamber together with an organometallic component of an element of the IIIrd main group, the concentration of the halide being so small that complete conversion of the organometallic component into a metal chloride does not take place.

## Revendications

1. Dispositif de dépôt d'une ou plusieurs couches, notamment cristallines, sur un ou plusieurs substrats (6), notamment cristallins, disposés sur un suscepteur (3) dans une chambre de réaction (2) d'un réacteur (1), dispositif dans lequel une paroi de chambre de réaction (4) pouvant être soumise à un chauffage actif par un dispositif de chauffage de chambre de réaction (11, 12) est placée en face du suscepteur (3) pouvant être soumis à un chauffage actif par un dispositif de chauffage de suscepteur (11) et un organe d'introduction de gaz (7) est prévu pour introduire des gaz de réaction dans la chambre de réaction, dans lequel le dispositif de chauffage de chambre de réaction (11, 12) comporte un canal de réfrigérant (13) et est placé, lorsque la paroi de chambre de réaction (4) est soumise à un chauffage actif, à distance du côté extérieur (18) de la paroi de chambre de réaction (4), **caractérisé en ce que** la paroi de chambre de réaction (4) peut être soumise au choix à un chauffage actif ainsi qu'à un refroidissement actif, ce pour quoi le canal de réfrigérant (13) forme un dispositif de refroidissement de chambre de réaction (12), la distance entre le dispositif de refroidissement de paroi de chambre de réaction (12) et la paroi de chambre de réaction (4) peut être modifiée au moyen d'un dispositif de déplacement se présentant notamment sous la forme d'un dispositif de levage de la position de chauffage à distance dans une position de refroidissement.

2. Dispositif selon la revendication 1, **caractérisé en ce que** la distance entre le dispositif de refroidissement de chambre de réaction (12) et la paroi de chambre de réaction (4) est égale à zéro ou à peu près à zéro dans la position de refroidissement de sorte que le côté extérieur (17) du canal
de réfrigérant est en contact de surface avec le côté extérieur (18) de la paroi de chambre de réaction (4).

3. Dispositif selon l'une ou plusieurs des revendications précédentes, **caractérisé en ce que** le dispositif de chauffage de paroi de chambre de réaction (12) est un serpentin de chauffage/refroidissement.

4. Dispositif selon l'une ou plusieurs des revendications précédentes, **caractérisé en ce que** le dispositif de déplacement déplace soit la paroi de chambre de réaction (4) par rapport au serpentin de chauffage/refroidissement (12) soit le serpentin de chauffage/refroidissement (12) par rapport à la paroi de chambre de réaction (4).

5. Dispositif selon l'une ou plusieurs des revendications précédentes, **caractérisé en ce que** la paroi de chambre de réaction (4), qui peut être déplacée en direction du serpentin de chauffage/refroidissement (12), est le plafond de la chambre de réaction et le dispositif de levage est un élément porteur de plafond (16) supportant le plafond.

6. Dispositif selon l'une ou plusieurs des revendications précédentes, **caractérisé par** des éléments élastiques (22) agissant sur le serpentin de chauffage/refroidissement (12) et destinés à solliciter élastiquement les spires du serpentin de chauffage/refroidissement (12) en direction de la paroi de chambre de réaction (4) afin que le côté inférieur (17) du serpentin de chauffage/refroidissement (12) reste en contact de surface avec le côté supérieur (18) de la paroi de chambre de réaction (4).

7. Dispositif selon l'une ou plusieurs des revendications précédentes, **caractérisé en ce que** le substrat (6) est disposé sur un porte-substrat (5) associé au suscepteur (3) de façon à pouvoir tourner.

8. Procédé de dépôt d'une ou plusieurs couches, notamment cristallines, sur un ou plusieurs substrats (6), notamment cristallins, disposés sur un suscepteur (3) dans une chambre de réaction (2) d'un réacteur (1), procédé dans lequel le suscepteur (3) est soumis à un chauffage actif jusqu'à une température de suscepteur de plus de 1000°C et, pour déposer la couche dans le procédé HVPE, la paroi de chambre de réaction (4), en face du suscepteur (3), est soumise à un chauffage actif jusqu'à une température de paroi de chambre de réaction qui est de l'ordre de +/- 200° autour de la température de suscepteur, dans lequel des gaz de réaction sont introduits dans la chambre de réaction (2) au moyen d'un organe d'introduction de gaz (7) lesquels gaz comportent au moins un hydrure et un halogénure métallique, dans lequel une autre couche est déposée dans le procédé MOVD dans la même chambre de réaction chronologiquement avant ou après le dépôt de la couche déposée dans le procédé HVPE, dans lequel les gaz de réaction comportent au moins un hydrure et un composé organométallique, **caractérisé en ce que**, lors de la mise en oeuvre du procédé MOCVD, la paroi de chambre de réaction (4) est refroidie à une température de paroi de chambre de réaction qui est plus de 200° au-dessous de la température de suscepteur, ce pour quoi un dispositif de chauffage de chambre de réaction (11, 12), comportant un canal de réfrigérant (13) et placé à distance du côté extérieur (18) de la paroi de chambre de réaction (4) lorsque la paroi de chambre de réaction (4) est soumise à un chauffage actif, est abaissé de la position de chauffage à distance dans une position de refroidissement au moyen d'un dispositif de levage ou un métal liquide, qui possède un point d'ébullition situé au-dessus de la température de paroi de chambre de réaction la plus élevée, s'écoule à travers des canaux de réfrigérant (14) disposés dans la paroi de chambre de réaction (4).

9. Procédé selon la revendication 8, **caractérisé en ce que** les gaz de réaction comportent au moins un élément du deuxième ou troisième groupe principal et un élément du cinquième ou sixième groupe principal.

10. Procédé selon l'une ou plusieurs des revendications 8 ou 9, **caractérisé en ce que** dans le procédé MOCVD l'élément du deuxième ou troisième groupe principal est le composé organométallique et l'élément du cinquième ou sixième groupe principal est l'hydrure et **en ce que** dans le procédé HVPE on utilise les mêmes matériaux de départ et en plus du HCl comme moyen de transport de l'élément du composé organométallique qui s'est désintégré lors de l'entrée dans une zone chaude de la chambre de réaction (2).

11. Procédé selon l'une ou plusieurs des revendications 8 à 10, **caractérisé en ce que** la paroi de chambre de réaction (4) est chauffée au moyen d'un serpentin de chauffage/refroidissement (12) et est refroidie, au contact du serpentin de chauffage/refroidissement (12), par le réfrigérant qui s'écoule à travers un canal de refroidissement (13) du serpentin de chauffage/refroidissement (12).

12. Procédé selon l'une ou plusieurs des revendications 8 à 11, **caractérisé par** un grand nombre d'éléments élastiques (22), répartis sur la périphérie, qui s'appuient en haut sur un support (20) et qui sollicitent en bas le serpentin de chauffage/refroidissement (12).

13. Procédé selon l'une ou plusieurs des revendications 8 à 12, **caractérisé en ce que**, lorsque des plafonds de chambre de réaction (4) sont chauffés ou refroidis, un halogénure, se présentant notamment sous la forme de HCl, est introduit conjointement avec un composé organométallique d'un élément du groupe principal III dans la chambre de réaction, la concentration en halogénure étant si faible qu'aucune conversion complète du composé organométallique en chlorure métallique ne se produit.
